# EUROPÄISCHE PATENTSCHRIFT

(11) **EP 2 642 544 B1**
(45) Veröffentlichungstag und Bekanntmachung des Hinweises auf die Patenterteilung: **01.10.2014**
(21) Anmeldenummer: 12161026.5
(22) Anmeldetag: 23.03.2012
(51) Int. Cl.: B06B 1/06, G10K 11/00, H01L 41/047, H01L 41/08, H01L 41/09, H01L 41/29

(54) **Anordnung aus einem Piezoaktor und einer flexiblen Leiterplatte**
Assembly comprising a piezo actuator and a flexible circuit board
Agencement à partir d'un piézoactionneur et d'une plaquette flexible

(43) Veröffentlichungstag der Anmeldung: 25.09.2013
(73) Patentinhaber: VEGA Grieshaber KG, 77709 Wolfach (DE)
(72) Erfinder: Gruhler, Holger, 78609 Tuningen (DE); Ohmayer, Gerd, 77716 Haslach (DE)
(74) Vertreter: Patentanwälte Westphal, Mussgnug & Partner

(56) Entgegenhaltungen:
- WO-A2-2011/139602
- US-A1- 2010 067 151
- US-B1- 6 472 610

## Beschreibung

Die vorliegende Erfindung betrifft eine Anordnung aus einem Piezoaktor und einer flexiblen Leiterplatte, mit wenigstens einer durch einen elektrisch leitfähigen Klebstoff hergestellten elektrischen und mechanischen Verbindung zwischen einem ersten Anschlusskontakt an der flexiblen Leiterplatte und einem zweiten Anschlusskontakt an dem Piezoaktor, wobei die Verbindung durch eine Öffnung in der flexiblen Leiterplatte geführt ist und wobei die miteinander verklebten Oberflächen der Anschlusskontakte einen im wesentlichen parallel und gleich orientierten Normalenvektor aufweisen.

Derartige Anordnungen, bei denen eine elektrische und mechanische Verbindung zwischen einer flexiblen Leiterplatte und einem Piezoaktor durch eine Klebeverbindung hergestellt wird, sind aus dem Stand der Technik bekannt und werden beispielsweise in sogenannten Vibrations-Grenzstandmessgeräten eingesetzt.

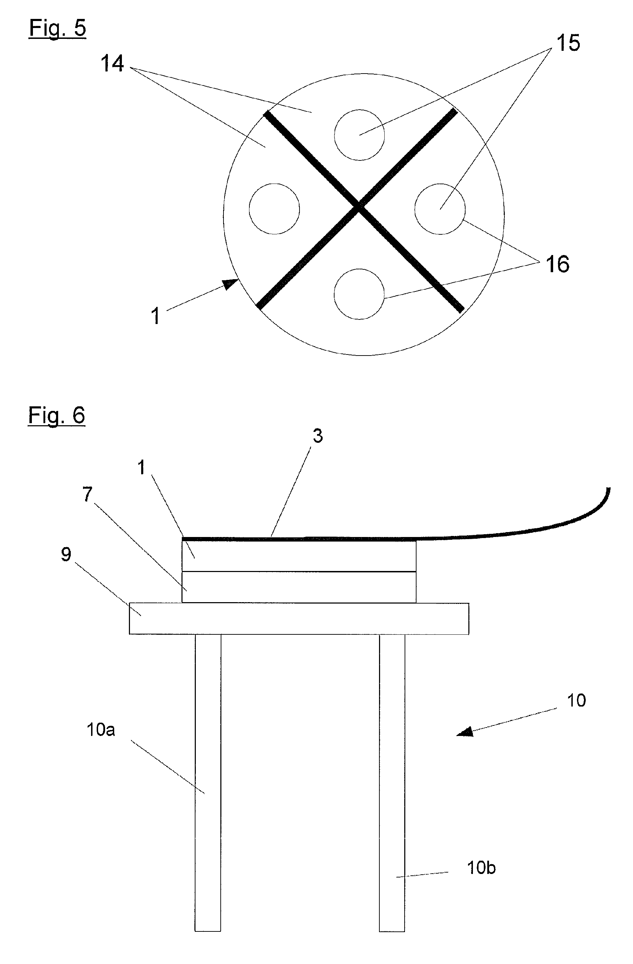

Der schematische Aufbau eines solchen Vibrationsgrenzstandmessgerätes ist in Figur 6 dargestellt.

Der schematische Aufbau in Figur 6 ist weder maßstabsgetreu noch vollständig und soll lediglich nach Art einer Prinzipsskizze die Funktion eines Vibrations-Grenzstandmessgerätes darstellen.

Das dargestellte Vibrations-Grenzstandmessgerät weist eine Schwinggabel 10 auf, die an einer Membran 9 angeordnet ist. Die Membran 9 ist Teil der Schwinggabel 10, wobei Zinken 10a, 10b der Schwinggabel 10 direkt an der Membran 9 angebunden sind und durch Verbiegen der Membran 9 aufeinander zu- bzw. voneinander wegbewegt werden.

Die Membran 9 ist in der Regel aus Edelstahl gefertigt und über einen Piezoaktor 1 in Schwingung versetzbar. Der Piezoaktor 1 ist über ein Keramikplättchen 7, das zwischen dem Piezoaktor 1 und der Membran 9 angeordnet ist, mit dieser verbunden. Das Keramikplättchen 7 ist vorgesehen, um die unterschiedlichen thermischen Ausdehnungskoeffizienten der Membran 9 und des Piezoaktors 1 einander anzupassen.

Eine Erregung des Piezoaktors 1 erfolgt über eine elektrische Spannung, die über eine flexible Leiterplatte 3 an der Oberseite des Piezoaktors 1 angelegt wird. Eine Unterseite des Piezoaktors 1 ist durchgehend metallisiert, sodass eine an der Oberseite angelegte Spannung auf Grund einer Segmentierung der Elektrode auf der Oberseite sowie einer unterschiedlichen Polarisation dieser Piezosegmente eine Schwingung des Piezoaktors 1 bewirkt. Die flexible Leiterplatte 3 ist im vorliegenden Beispiel als sogenannte Flexleitung, d. h. als flexibel ausgebildete federartige Leiterplatte mit darauf angeordneten Leiterbahnen, ausgebildet.

Die flexible Leiterplatte 3 ist an den zu kontaktierenden Punkten des Piezoaktors 1 mit einem leitfähigen Klebstoff mit diesem verbunden, sodass ausschließlich an den durch den Klebstoff verbundenen Punkten eine Spannung in den Piezoaktor 1 eingeleitet wird. Der Piezoaktor 1 sowie das Keramikplättchen 7 und die Membran 9 sind ebenfalls miteinander verklebt.

Um mit dem Piezoaktor 1 eine Vibration der Schwinggabel 10 zu erzeugen und gleichzeitig eine Frequenzverschiebung oder Dämpfung der Schwinggabel 10 zu detektieren, ist der Piezoaktor 1 in vier Segmente geteilt. Der Piezoaktor 1 ist dabei in der Regel in Draufsicht kreisrund ausgebildet und in vier Quadranten unterteilt, die durch Anlegen einer Spannung jeweils einzeln angesteuert werden können. Zur Erzeugung einer Schwingung werden jeweils zwei diagonal gegenüberliegende Quadranten mit einer Spannung beaufschlagt, während die anderen beiden Quadranten zur Detektion der erzeugten Schwingung benutzt werden. Auf diese Weise kann gleichzeitig eine Schwingung erzeugt und detektiert werden.

Bei den meisten aus dem Stand der Technik üblichen Anordnungen aus einem Piezoaktor 1 und einer Leiterplatte 3 ist die Leiterplatte 3 zum Anlegen der Spannung mit einem ersten Anschlusskontakt 11 versehen, der korrespondierend zu einem zweiten Anschlusskontakt 12 auf dem Piezoaktor 1 angeordnet ist. Der erste Anschlusskontakt 11 an der Leiterplatte 3 ist dafür in der Regel an der dem Piezoaktor 1 zugewandten Seite der flexiblen Leiterplatte 3 angeordnet, sodass zwischen dem ersten Anschlusskontakt 11 und dem zweiten Anschlusskontakt 12 durch Auftragen eines leitfähigen Klebers und Verpressen der beiden Bauteile eine elektrisch leitfähige Verbindung hergestellt werden kann.

Auf Grund der geringen Klebefläche und des anschließenden Verpressens muss eine Klebstoffmenge sehr klein und sehr genau bemessen sein, da ansonsten durch ein Verlaufen des Klebstoffes bzw. ein Herausquellen durch das Verpressen Kurzschlüsse zu den angrenzenden Quadranten des Piezoaktors 1 zu befürchten sind. Eine exakt reproduzierbare Dosierung einer sehr kleinen Menge eines hochviskosen Mediums ist auf Grund der bei kleinen Volumina dominierenden Oberflächenkräfte nur schwierig zu bewerkstelligen, sodass ein erhöhter Herstellungsaufwand besteht.

Problematisch bei dieser Vorgehensweise ist es außerdem, dass eine im ersten Anlauf falsche Ausrichtung der flexiblen Leiterplatte 3 nicht mehr korrigiert werden kann, da ansonsten der leitfähige Kleber zwischen den Anschlusskontakten 11, 12 verschmiert und als Folge ebenfalls mit Kurzschlüssen zwischen den einzelnen Quadranten des Piezoaktors 1 bzw. den korrespondierend angeordneten Kontakten der flexiblen Leiterplatte 3 zu rechnen ist. Es ist darüber hinaus negativ, dass die flexible Leiterplatte 3 und der Piezoaktor 1 auf Grund der dazwischen befindlichen Klebeverbindung 5 nicht unmittelbar aufeinander angeordnet werden können. Negativ ist außerdem, dass durch ein Verpressen von der flexiblen Leiterplatte 3 und dem Piezoaktor 1 die dazwischen befindlichen Klebeverbindungen flach gedrückt und damit gegebenenfalls überschüssiger Klebstoff seitlich neben den Anschlusskontakten 11, 12 herausgedrückt wird. Dies erhöht die Gefahr von Kurzschlüssen.

Auf Grund der rein stoffschlüssigen Verbindung zwischen flexibler Leiterplatte 3 und Piezoaktor 1 muss jegliche spätere Belastung der Klebeverbindung durch Kohäsions- und Adhäsionskräfte aufgenommen werden. Eine mechanische Belastbarkeit der Klebeverbindung ist damit nur äußerst gering.

Nach dem Aufbringen des Klebstoffes muss die flexible Leiterplatte 3 planparallel und exakt zu dem Piezoaktor 1 positioniert werden. Aus den oben dargestellten Gründen ist eine nachträgliche Positionskorrektur nicht möglich.

Es existieren Ansätze, bei denen die flexible Leiterplatte 3 im Bereich der Anschlusskontakte 11, 12 mit einer ersten Öffnung versehen ist, durch die überschüssiger Klebstoff entweichen kann. Bei diesen Anordnungen besteht jedoch nach wie vor der Nachteil, dass der Klebstoff zuerst auf den Piezoaktor 1 aufgebracht und anschließen die flexible Leiterplatte 3 mit diesem verpresst wird, sodass eine nachträgliche Korrektur der Ausrichtung der flexiblen Leiterplatte 3 relativ zu dem Piezoaktor 1 nicht möglich ist. Darüber hinaus wurde festgestellt, dass aufgrund der geringen Spalthöhe des verwendeten Klebstoffes in dem Spalt zwischen der flexiblen Leiterplatte 3 und dem Piezoaktor 1 hohe Kapillarkräfte herrschen, durch die Klebstoff auch über die vorgesehenen Anschlusskontakte hinaus zwischen Piezoaktor 1 und flexibler Leiterplatte 3 gesaugt wird. Eine solche Ausbreitung des elektrisch leitfähigen Klebstoffes zwischen dem Piezoaktor und der flexiblen Leiterplatte wird durch minimale Unebenheiten oder einer minimal von der Parallelität abweichende Ausrichtung von flexibler Leiterplatte und Piezoaktor begünstigt. Durch diesen Effekt entstehen, wie oben angedeutet, Kurzschlüsse, die einen Defekt der kompletten Füllstandmessanordnung zur Folge haben.

Es ist die Aufgabe der vorliegenden Erfindung die oben beschriebenen Nachteile zu beheben und eine verbesserte Anordnung sowie Prozessführung zur Verfügung zu stellen.

Diese Aufgaben werden durch eine Anordnung gemäß Patentanspruch 1, eine Montagehilfe gemäß Patentanspruch 9 sowie ein Verfahren zur Herstellung einer solchen Anordnung gemäß Patentanspruch 10 gelöst.

Eine erfindungsgemäße Anordnung aus einem Piezoaktor 1 und einer flexiblen Leiterplatte weist wenigstens eine durch einen elektrisch leitfähigen Klebstoff hergestellte elektrische und mechanische Verbindung zwischen einem ersten Anschlusskontakt an der Leiterplatte und einem zweiten Anschlusskontakt an dem Piezoaktor auf, wobei die Verbindung durch eine Öffnung in der Leiterplatte geführt ist und wobei die miteinander verklebten Oberflächen der Anschlusskontakte einen im Wesentlichen parallel und gleichorientierten Normalenvektor aufweisen und der zweite Anschlusskontakt aus einer Dünnschichtelektrode und wenigstens einer Dickschichtelektrode besteht.

Bei einer erfindungsgemäßen Anordnung wird auf diese Weise eine nietenartige Klebeverbindung geschaffen, wobei die Anschlusskontakte an dem Piezoaktor an der flexiblen Leiterplatte gleichsinnig orientiert sind. Dadurch, dass in der flexiblen Leiterplatte eine Öffnung vorgesehen ist, durch die der elektrisch leitfähige Klebstoff zur Verklebung eingebracht werden kann, wobei er gleichzeitig die Ränder der Öffnung auf der von dem Piezoaktor wegweisenden Seite der flexiblen Leiterplatte überdeckt entsteht eine pilzförmige oder nietenartige Klebeverbindung, die im Vergleich zu reinen Kontaktklebungen eine wesentlich erhöhte mechanische Stabilität aufweist. Durch die Verwendung einer Dünnschichtelektrode und einer Dickschichtelektrode wird außerdem erreicht, dass bei einem Verpressen der flexiblen Leiterplatte mit dem Piezoaktor vor dem Einbringen des elektrisch leitfähigen Klebstoffes und einem Rand der Dickschichtelektrode eine erhöhte Krafteinwirkung erreicht wird, durch die eine Dichtwirkung zwischen dem Piezoaktor und der flexiblen Leiterplatte erreicht wird. Auf diese Weise kann verhindert werden, dass sich der elektrisch leitfähige Klebstoff auf Grund von Kapillarkräften über den Rand der Dickschichtelektrode hinaus zwischen dem Piezoaktor und der flexiblen Leiterplatte ausbreitet und Kurzschlüsse verursacht.

Eine besonders einfache Anordnung kann erreicht werden, wenn die Dickschichtelektrode auf der Dünnschichtelektrode angeordnet ist.

Die in Dünnschichttechnik aufgebrachte Dünnschichtelektrode, z.B. eine Kupfer-Nickel-Elektrode mit einer Schichtdicke von weniger als 1 µm, kann beispielsweise durch chemische Gasphasenabscheidung oder physikalische Gasphasenabscheidung, beispielsweise Aufdampfen oder Kathodenzerstäubung (Sputtern) vollflächig, selektiv oder in einem Lift-off-Prozess aufgebracht werden. Eine vollflächige, möglichst exakt begrenzte und reproduzierbare Metallisierung durch die Dünnschichtelektrode ist notwendig um den Piezoaktor bzw. einzelne Quadranten des Piezoaktors möglichst vollflächig mit Spannung beaufschlagen zu können.

Auf der Dünnschichtelektrode kann dann eine Dickschichtelektrode, beispielsweise eine Silberdickschicht mit einer Schichtdicke von mehr als 10 µm aufgebracht werden. Die Dickschichtelektrode kann beispielsweise durch ein Siebdruckverfahren aufgebracht und anschließend ausgehärtet werden.

Falls es aus prozesstechnischen Gründen, z. B. auf Grund einer thermisch empfindlichen Dünnschichtelektrode notwendig ist, kann auch die Dickschichtelektrode erst auf den Piezoaktor aufgebracht und ausgehärtet und anschließend zur vollflächigen Spannungseinkopplung die Dünnschichtelektrode aufgebracht werden.

Um eine möglichst vollflächige Stromeinkopplung im Piezoaktor zu gewährleisten und gleichzeitig eine hohe Sicherheit gegenüber Kurzschlüssen zu erreichen ist es sinnvoll, wenn die Dickschichtelektrode eine geringere Fläche als die Dünnschichtelektrode aufweist. Auf diese Weise wird erreicht, dass der elektrisch leitfähige Klebstoff nur im Bereich der geringeren Fläche der Dickschichtelektrode Verwendung findet und die Stromeinkopplung in den Piezoaktor über die darüber hinaus aufgebrachte Dünnschichtelektrode erfolgt.

Eine besonders einfache und symmetrische Ausgestaltung wird erreicht, wenn die Dickschichtelektrode kreisförmig ausgebildet ist. Durch eine kreisförmige Ausgestaltung der Dicksichtelektrode kann besonders einfach eine geschlossene Außenkante der Dickschichtelektrode erreicht werden, die nicht durch Eckabschnitte, die beispielsweise bei rechteckförmigen Dickschichtelektroden vorhanden wären, unterbrochen ist.

Alternativ kann die Dickschichtelektrode auch ringförmig ausgebildet sein, wobei in diesem Fall der Vorteil besteht, dass durch die ringförmig ausgebildete Dickschichtelektrode zusätzlich eine Art "Wanne" bzw. "Umrandung" für den elektrisch leitfähigen Klebstoff geschaffen wird.

Um die oben angesprochene Dichtwirkung zu erreichen, ist es sinnvoll, wenn die Dickschichtelektrode einen ersten Durchmesser aufweist, der größer als ein Durchmesser der Öffnung in der flexiblen Leiterplatte ist. Auf diese Weise liegt die flexible Leiterplatte vollständig auf dem Rand der Dickschichtelektrode auf und schafft so eine umlaufende Dichtkante. Der erste Durchmesser der Dickschichtelektrode und der Durchmesser der Öffnung in der flexiblen Leiterplatte sind bevorzugt derart aufeinander abgestimmt, dass eine ausreichende Klebefläche für eine mechanische Verbindung zwischen der flexiblen Leiterplatte und dem Piezoaktor geschaffen wird und gleichzeitig eine gute Dichtwirkung erreicht wird.

Um einen gleichmäßigen Anpressdruck und damit eine umlaufend gleiche Dichtwirkung zu erreichen ist es sinnvoll, wenn die Dickschichtelektrode und die Öffnung in der flexiblen Leiterplatte konzentrisch zueinander ausgerichtet sind.

Um eine weitere Begrenzung der Ausdehnung des elektrisch leitfähigen Klebstoffes zwischen der flexiblen Leiterplatte und dem Piezoaktor zu erreichen, ist es außerdem möglich, eine kreisförmige und eine ringförmige Dickschichtelektrode vorzusehen. Auf diese Weise wird einerseits eine gute mechanische Verbindung im Bereich der kreisförmigen Dickschichtelektrode erreicht und zwischen der kreisförmigen Dickschichtelektrode und der ringförmigen Dickschichtelektrode eine Art "Graben" geschaffen, in dem sich überschüssiger und auf Grund von Kapillarkräften ausdehnender elektrisch leitfähiger Klebstoff sammeln kann.

Die vorstehend beschriebene Anordnung lässt sich besonders günstige mit einer Montagehilfe herstellen, wobei die Montagehilfe im Wesentlichen plattenförmig ausgebildet ist und im Bereich der wenigstens einen Verbindung je wenigstens eine zweite Öffnung aufweist, wobei ein zweiter Durchmesser der zweiten Öffnung in der Montagehilfe und ein erster Durchmesser der Dickschichtelektrode derart aufeinander abgestimmt sind, dass ein in Richtung der Anordnung gerichtete und auf die flexible Leiterplatte wirkende Kraft derart auf einen Rand der Dickschichtelektrode wirkt, dass eine Abdichtung gegenüber dem Klebstoff erzielt wird.

Durch eine Abstimmung des zweiten Durchmessers der in der Montagehilfe vorgesehene zweiten Öffnung auf den ersten Durchmesser Dickschichtelektrode derart, dass auf die flexible Leiterplatte ein Druck derart ausgeübt wird, dass an dem umlaufenden Rand der Schichtelektrode eine maximale Kraftwirkung und damit Abdichtungswirkung erzielt wird, ermöglicht eine besonders zuverlässige Herstellung der zuvor beschriebenen Anordnung.

Zur Herstellung der zuvor beschriebenen Anordnung werden in einem ersten Schritt die flexible Leiterplatte und der Piezoaktor relativ zueinander angeordnet, die Montagehilfe relativ zu der flexiblen Leiterplatte ausgerichtet, die flexible Leiterplatte und der Piezoaktor mit Hilfe der Montagehilfe miteinander verpresst, der elektrisch leitfähige Klebstoff in die wenigstens eine erste Öffnung der flexiblen Leiterplatte eingebracht und ausgehärtet.

Ein ausrichtendes Anordnen der flexiblen Leiterplatte und des Piezoaktors bedeutet in diesem Zusammenhang, dass in der flexiblen Leiterplatte vorgesehenen Öffnungen möglichst konzentrisch zu den auf dem Piezoaktor vorgesehenen Dickschichtelektroden ausgerichtet werden. Ebenso wird die Montagehilfe derart angeordnet, dass die Öffnungen in der Montagehilfe möglichst konzentrisch zu den Öffnungen in der flexiblen Leiterplatte und damit konzentrisch zu den darunter befindlichen Dickschichtelektroden auf dem Piezoaktor ausgerichtet sind. Durch eine Abstimmung des Durchmessers der Öffnungen in der Montagehilfe auf den Durchmesser der Dickschichtelektroden wird erreicht, dass bei einem Verpressen die flexible Leiterplatte in einem bestimmten Abstand zum Rand der Dickschichtelektrode derart niedergedrückt wird, dass an dem Rand der Dickschichtelektrode eine Dichtwirkung hinsichtlich des eingebrachten elektrisch leitfähigen Klebstoffes erreicht wird.

Ein bevorzugter Durchmesser für die Dickschichtelektrode beträgt 2,5mm, wobei der Durchmesser für die zweite Öffnung in der Montagehilfe dann bevorzugt 3,2mm beträgt.

Die vorliegende Erfindung wird nachfolgend anhand von drei Ausführungsbeispielen unter Bezugnahme auf die beigefügten Figuren eingehend erläutert.

Es zeigen:
- Fig. 1: eine Anordnung gemäß dem Stand der Technik,
- Fig. 2: eine erstes Ausführungsbeispiel gemäß der vorliegenden Erfindung in Montageposition,
- Fig. 3: ein zweites Ausführungsbeispiel gemäß der vorliegenden Erfindung in Montageposition,
- Fig. 4: eine drittes Ausführungsbeispiel gemäß der vorliegenden Erfindung in Montageposition,
- Fig. 5: einen Piezoaktor in Draufsicht und
- Fig. 6: eine Grenzstands-Messanordnung (schon behandelt)

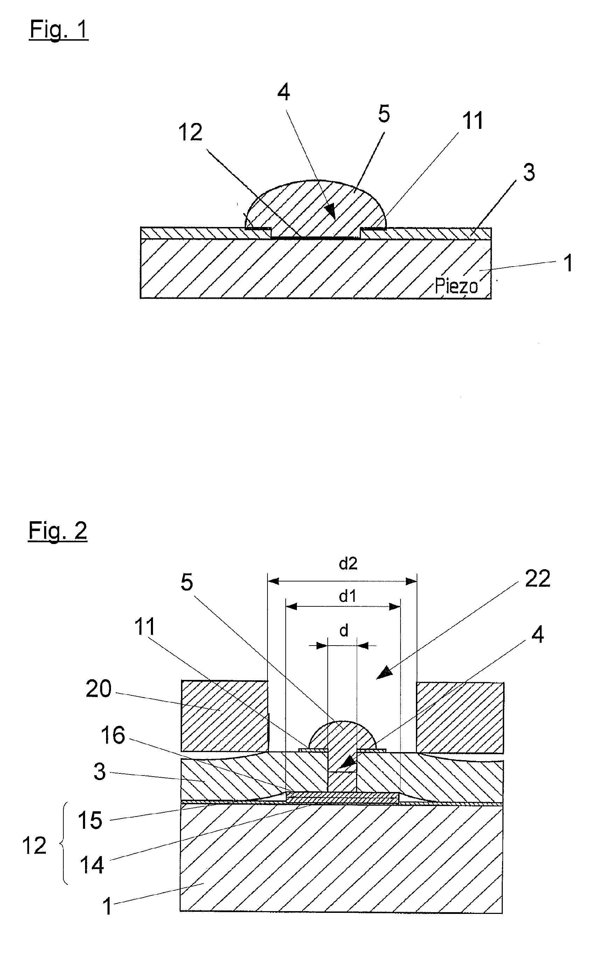

Figur 1 zeigt eine Anordnung aus einem Piezoaktor 1, auf dem eine flexible Leiterplatte 3 angeordnet ist, wobei eine elektrische und mechanische Verbindung zwischen der flexiblen Leiterplatte 3 und dem Piezoaktor 1 durch einen elektrisch leitfähigen Klebstoff geschaffen ist. Der elektrisch leitfähige Klebstoff verbindet einen ersten Anschlusskontakt 11, der ringförmig auf der von dem Piezoaktor 1 abgewandten Seite der flexiblen Leiterplatte 3 eine erste Öffnung 4 in der flexiblen Leiterplatte 3 ringförmig umgeben angeordnet ist. Ein zweiter Anschlusskontakt 12 ist auf dem Piezoaktor 1 der flexiblen Leiterplatte 3 zugewandt angeordnet und kreisförmig ausgebildet.

Durch feine Unebenheiten in dem Piezoaktor 1 oder der flexiblen Leiterplatte 3 entstehen feine Zwischenräume zwischen diesen Komponenten, wodurch hohe Kapillarkräfte den hochviskosen elektrisch leitfähigen Klebstoff in die Zwischenräume saugen. Dadurch, dass die Oberflächeneigenschaften in diesem Bereich nur schwierig weiter verbessert werden können, ist eine Vermeidung des Kapillareffektes nahezu unmöglich, sodass bei dieser Anordnung eine durchschnittliche Ausfallwahrscheinlichkeit auf Grund von Kurzschlüssen von ca. 19 % ermittelt wurde.

In Figur 2 ist eine erfindungsgemäße Anordnung gezeigt, bei der der zweite Anschlusskontakt 12 durch eine Dünnschichtelektrode 14 und eine auf der Dünnschicht 14 angeordnete Dickschichtelektrode 15 gebildet ist. Die Dünnschichtelektrode 14 dient zur annähernd vollflächigen elektrischen Kontaktierung des Piezoaktors 1, wobei die Dickschichtelektrode 15 im Wesentlichen in einem Bereich unterhalb der ersten Öffnung 4 in der flexiblen Leiterplatte 3 angeordnet ist. Ein erster Durchmesser d₁ der Dickschichtelektrode 15 ist in diesem Bereich etwas größer als ein Durchmesser d der Öffnung 4, durch die elektrisch leitfähiger Klebstoff zur Herstellung der elektrischen und mechanischen Verbindung 5 eingefüllt wird. In Figur 2 ist außerdem eine Montagehilfe 20 gezeigt, die bei der Herstellung der erfindungsgemäßen Anordnung Verwendung findet. Die Montagehilfe 20 ist im Wesentlichen plattenförmig ausgebildet und weist korrespondierend zu den Öffnungen 4 in der flexiblen Leiterplatte 3 ausgebildete zweite Öffnungen 22 auf. Ein zweiter Durchmesser d₂ der zweiten Öffnungen 22 ist etwas größer gewählt als der erste Durchmesser d₁ der Dickschichtelektrode 15, sodass durch ein Verpressen der Komponenten bei der Montage eine leichte Verbiegung der flexiblen Leiterplatte 3 eintritt und in einem umlaufenden Rand 16 der Dickschichtelektrode 15 eine Dichtwirkung für eine nach der Verpressung eingebrachten elektrisch leitfähigen Klebstoff erreicht wird.

Der zweite Durchmesser d₂ der zweiten Öffnung 22 in der Montagehilfe 20 ist bevorzugt um 28 % größer als der erste Durchmesser d₁ der Dickichtelektrode 15 gewählt. In einem konkreten Ausführungsbeispiel ist der erste Durchmesser d₁ der Dickschichtelektrode 15 2,5mm und der zweite d₂ der zweiten Öffnung 22 in der Montagehilfe 20 3,2mm. Der Durchmesser d der Öffnung 4 in der flexiblen Leiterplatte 3 beträgt in diesem Ausführungsbeispiel 1,2mm.

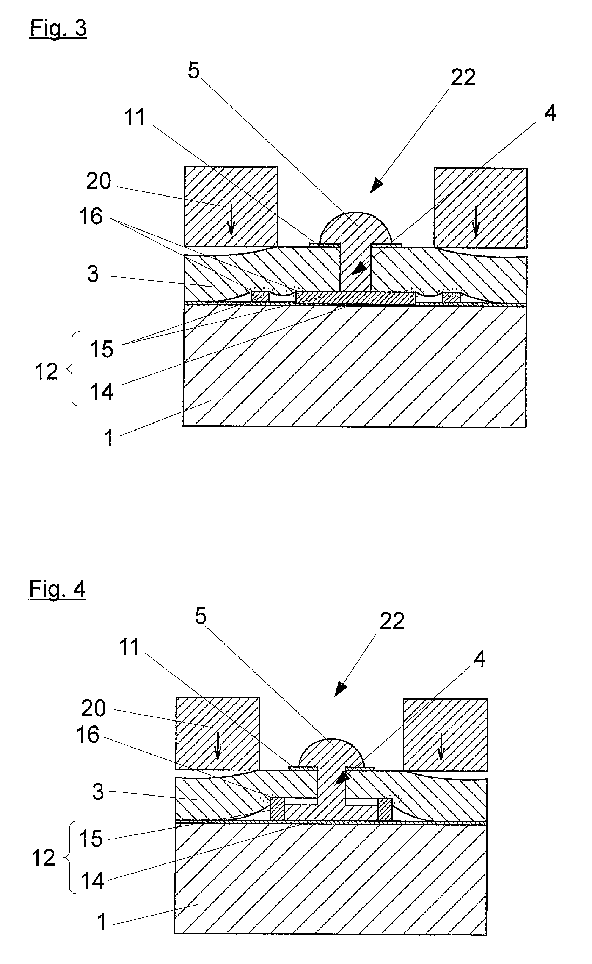

Figur 3 zeigt ein weiteres Ausführungsbeispiel der erfindungsgemäßen Anordnung sowie der Montagehilfe 20.

Im Unterschied zur Figur 2 ist die Dickschichtelektrode 15 im vorliegenden Ausführungsbeispiel zweigeteilt ausgebildet, wobei ein erster Teil, analog zu Figur 2, kreisförmig unmittelbar unterhalb der Öffnung 4 in der flexiblen Leiterplatte 3 ausgebildet ist. Zusätzlich ist zu dem kreisförmigen Teil der Dickschichtelektrode 15 ein ringförmiger Abschnitt vorgesehen, der beabstandet und die kreisförmige Dickschichtelektrode 15 umgebend angeordnet ist. Durch ein derartige Ausgestaltung der Dickschichtelektrode 15 wird einerseits an dem umlaufenden Rand 16 der kreisförmigen Dickschichtelektrode 15 bei einem Verpressen der Montagehilfe 20 mit der flexiblen Leiterplatte 3 und dem Piezoaktor 1 eine Dichtwirkung erzielt, die ebenfalls an den innenseitig und außenseitig umlaufenden Kanten der ringförmigen Dicksichtelektrode 15 auftritt. Durch beabstandete Anordnung der ringförmigen Dickschichtelektrode 15 zu der kreisförmigen Dickschichtelektrode 15 wird außerdem eine Art "Graben" geschaffen, in dem sich überschüssiger Leitfähiger Klebstoff ansammeln kann. Dieser "Graben" ist durch die ringförmige Dickschichtelektrode nach außen hin begrenzt, sodass Kurzschlüsse durch ein weiteres sich Ausbreiten des elektrisch leitfähigen Klebstoffes wirkungsvoll vermieden werden können.

Figur 4 zeigt ein weiteres alternatives Ausführungsbeispiel der erfindungsgemäßen Anordnung.

In dem in Figur 4 gezeigten Ausführungsbeispiel ist lediglich eine ringförmige Dicksichtelektrode 15 vorgesehen, die im Montagezustand einerseits an ihrem umlaufenden Rand 16 eine erhöhte Dichtwirkung ermöglicht und gleichzeitig im Inneren des Ringes eine Art "Wanne" für den durch die Öffnung 4 in der flexiblen Leiterplatte 3 eingeführten elektrisch leitfähigen Klebstoff 5 bildet.

Figur 5 zeigt den Piezoaktor 1 aus Figur 2 in Draufsicht, wobei der Piezoaktor 1 wie dies zur Realisierung einer Antriebseinrichtung für eine Grenzstandmesseinrichtung üblich ist, in vier Segmente aufgeteilt. Die vier Segmente sind jeweils mit der Dünnschichtelektrode 14 vollständig überzogen, weisen jedoch einen ausreichenden Abstand zueinander auf, um eine Isolierung der Segmente gegeneinander zu gewährleisten. In einem Zentralbereich der Dünnschichtelektroden 14 ist in jedem Segment jeweils eine kreisförmige Dickschichtelektrode 15 angeordnet, die jeweils durch einen umlaufenden Rand 16 begrenzt ist. Der umlaufende Rand 16 gewährleistet bei einer Montage der erfindungsgemäßen Anordnung die verbesserte Dichtwirkung gegenüber den elektrisch leitfähigen Klebstoff, sodass mit der in den Figuren 2 und 5 gezeigten Anordnung eine Reduktion der kurzschlussbedingten Ausfälle von - wie oben angesprochen - 19 % auf 3 % erreicht werden konnte. Durch eine Erhöhung der Anpresskraft beim Montagevorgang konnte die kurzschlussbedingte Ausfallrate sogar auf 0 % reduziert werden.

Die Montage der erfindungsgemäßen Anordnungen erfolgt mit folgenden Schritten:

In einem ersten Schritt werden auf den Piezoaktor 1 die Dünnschichtelektrode 14 und die Dickschichtelektrode 15 in geeigneter Größe aufgebracht. Die Dünnschichtelektrode 14 wird in der Regel durch chemische oder physikalische Gasphasenabscheidung annähern vollflächig auf die Segmente des Piezoaktors 1 aufgebracht. Die Dickschichtelektroden 15 werden anschließend

oder, wenn dies die Prozessführung erfordert, vor der Dünnschichtelektrode 14 - jeweils in einem Zentralbereich der einzelnen Segmente des Piezoaktors 1 kreisförmig, beispielsweise durch ein Siebdruckverfahren aufgebracht und ausgehärtet.

Der fertig strukturierte Piezoaktor 1 und die flexible Leiterplatte 3 werden anschließend relativ zueinander ausgerichtet. Da die flexible Leiterplatte 3 korrespondierend zu den Dickschichtelektroden 15 angeordnete Öffnungen 4 aufweist, bedeutet eine Ausrichtung von flexibler Leiterplatte 3 und Piezoaktor 1 relativ zueinander, dass die Öffnungen 4 über den jeweils zugehörigen Dickschichtelektroden 15 angeordnet werden. Die zueinander ausgerichteten Elemente Piezoaktor 1 und flexible Leiterplatte 3 werden zur Montage relativ zu der Montagehilfe 20 ausgerichtet, d. h. die in der flexiblen Leiterplatte 3 vorgesehenen Öffnungen 4 werden konzentrisch zu den zweiten Öffnungen 22 in der Montagehilfe 20 ausgerichtet. Je nach Prozessführung kann eine Ausrichtung von flexibler Leiterplatte 3 und Piezoaktor 1 auch anhand einer festvormontierten Montagehilfe 20 erfolgen.

Sofern sämtliche Elemente korrekt zueinander ausgerichtet sind, wird mittels der Montagehilfe 20 eine zur Erzielung der Dichtwirkung an dem umlaufenden Rand 16 geeignet dimensionierte Kraft in Richtung des Piezoaktors 1 eingebracht und anschließend - gegebenenfalls nach einer weiteren Kontrolle der korrekten Ausrichtung der einzelnen Komponenten - eine vorgegebene Menge eines leitfähigen Klebers in die Öffnung 4 der flexiblen Leiterplatte 3 eingebracht.

Die vorgegebene Menge des leitfähigen Klebstoffes ist derart dimensioniert, dass der erste Anschlusskontakt 11, der die Öffnung 4 in der flexiblen Leiterplatte 3 ringförmig umgibt wenigstens teilweise kuppelartig abgedeckt wird, sodass eine pilz- und nietenförmige Klebeverbindung entsteht, die gleichzeitig die elektrische Verbindung zwischen dem ersten Anschlusskontakt 11 und dem zweiten Anschlusskontakt 12 herstellt. Nach einem Aushärten der elektrischen und mechanischen Verbindung 5 respektive des verwendeten elektrisch leitfähigen Klebstoffes kann die zur Verpressung aufgewendete Kraft entfallen und die Montagehilfe 20 entfernt werden. Die dann miteinander fest mechanisch und elektrisch verbundenen Komponenten (Piezoaktor 1 und flexible Leiterplatte 3) können dann zur weiteren Verwendung in die Anordnung gemäß Figur 6 eingesetzt werden.

### Bezugszeichenliste

- 1: Piezoaktor

- 3: flexible Leiterplatte
- 4: erste Öffnung
- 5: elektrische und mechanische Verbindung

- 7: Keramikplättchen

- 9: Membran
- 10: Schwinggabel
- 10a: Zinken
- 10b: Zinken
- 11: erster Anschlusskontakt
- 12: zweiter Anschlusskontakt

- 14: Dünnschichtelektrode
- 15: Dickschichtelektrode
- 16: Kante / Rand

- 20: Montagehilfe

- 22: zweite Öffnung

- d₁: erster Durchmesser
- d₂: zweiter Durchmesser
- d: Durchmesser

## Patentansprüche

1. Anordnung aus einem Piezoaktor (1) und einer flexiblen Leiterplatte (3), mit wenigstens einer durch einen elektrisch leitfähigen Klebstoff hergestellten elektrischen und mechanischen Verbindung (5) zwischen einem ersten Anschlusskontakt (11) an der Leiterplatte und einem zweiten Anschlusskontakt (12) an dem Piezoaktor (1),
wobei die Verbindung (5) durch eine Öffnung (4) in der flexiblen Leiterplatte (3) geführt ist und
wobei die miteinander verklebten Oberflächen der Anschlusskontakte (11, 12) einen im wesentlichen parallelen und gleich orientierten Normalenvektor aufweisen,
**dadurch gekennzeichnet, dass**
der zweite Anschlusskontakt (12) aus wenigstens einer Dünnschichtelektrode (14) mit einer Schichtdicke von weniger als einem Mikrometer und wenigstens einer Dickschichtelektrode (15) mit einer Schichtdicke von mehr als zehn Mikrometern besteht.

2. Anordnung nach Anspruch 1,
**dadurch gekennzeichnet, dass**
die Dickschichtelektrode (15) auf der Dünnschichtelektrode (14) angeordnet ist.

3. Anordnung nach Anspruch 2
**dadurch gekennzeichnet, dass**
die Dickschichtelektrode (15) eine geringere Fläche als die Dünnschichtelektrode (14) aufweist.

4. Anordnung nach einem der vorhergehenden Ansprüche,
**dadurch gekennzeichnet, dass**
die Dickschichtelektrode (15) kreisförmig ausgebildet ist.

5. Anordnung nach einem der Ansprüche 1 bis 3,
**dadurch gekennzeichnet, dass**
die Dickschichtelektrode (15) ringförmig ausgebildet ist.

6. Anordnung nach einem der vorhergehenden Ansprüche,
**dadurch gekennzeichnet, dass**
die Dickschichtelektrode (15) einen ersten Durchmesser d₁ aufweist, der größer als ein Durchmesser d der Öffnung ist.

7. Anordnung nach einem der vorhergehenden Ansprüche,
**dadurch gekennzeichnet, dass**
die Dickschichtelektrode (15) und die Öffnung (4) konzentrisch ausgerichtet sind.

8. Anordnung nach einem der vorhergehenden Ansprüche,
**dadurch gekennzeichnet, dass**
eine kreisförmige und eine ringförmige Dickschichtelektrode (15) vorgesehen sind.

9. Montagehilfe (20) für eine Anordnung gemäß einem der vorhergehenden Ansprüche, wobei die Montagehilfe (20) im Wesentlichen plattenförmig ausgebildet ist und im Bereich der wenigstens einen Verbindung (5) je wenigstens eine zweite Öffnung (22) aufweist,
**dadurch gekennzeichnet, dass**
ein zweiter d₂ Durchmesser der zweiten Öffnung (4) in der Montagehilfe (20) und ein erster Durchmesser d₁ der Dickschichtelektrode (15) derart aufeinander abgestimmt sind, dass eine in Richtung der Anordnung gerichtete und auf die flexible Leiterplatte (3) wirkende Kraft derart auf einen Rand der Dickschichtelektrode wirkt, dass eine Abdichtung gegenüber dem Klebstoff erzielt wird.

10. Verfahren zur Herstellung einer Anordnung gemäß einem der Ansprüche 1 bis 8, mit den Schritten:
ausrichtendes Anordnen einer flexiblen Leiterplatte (3) auf einen Piezoaktor (1),
Ausrichten einer Montagehilfe (20) relativ zu der flexiblen Leiterplatte (3),
Verpressen des Flexleiters und des Piezoaktors mit Hilfe der Montagehilfe,
Einbringen des Klebstoffes in die Öffnung der Leiterplatte und
Aushärten des Klebstoffes.

## Claims

1. An arrangement comprising a piezo actuator (1) and a flexible printed circuit board (3), with at least one electrical and mechanical connection (5) produced by an electrically conductive adhesive between a first terminal contact (11) on the printed circuit board and a second terminal contact (12) on the piezo actuator (1), wherein the connection (5) is led through an opening (4) in the flexible printed circuit board (3) and wherein the surfaces of the terminal contacts (11, 12) secured to each other by adhesion have a substantially parallel normal vector orientated in the same way, **characterized in that** the second terminal contact (12) comprises at least one thin-layer electrode (14) with a layer thickness of less than one micrometre and at least one thick-layer electrode (15) with a layer thickness of more than ten micrometres.

2. An arrangement according to claim 1, **characterized in that** the thick-layer electrode (15) is arranged on the thin-layer electrode (14).

3. An arrangement according to claim 2, **characterized in that** the thick-layer electrode (15) has a smaller area than the thin-layer electrode (14).

4. An arrangement according to any one of the preceding claims, **characterized in that** the thick-layer electrode (15) is made circular.

5. An arrangement according to any one of claims 1 to 3, **characterized in that** the thick-layer electrode (15) is made annular.

6. An arrangement according to any one of the preceding claims, **characterized in that** the thick-layer electrode (15) has a first diameter d₁ which is larger than a diameter d of the opening.

7. An arrangement according to any one of the preceding claims, **characterized in that** the thick-layer electrode (15) and the opening (4) are aligned in a concentric manner.

8. An arrangement according to any one of the preceding claims, **characterized in that** a circular and an annular thick-layer electrode (15) are provided.

9. An assembly aid (20) for an arrangement according to any one of the preceding claims, wherein the assembly aid (20) is designed substantially in the form of a plate and has at least one second opening (22) in each case in the region of the at least one connection (5), **characterized in that** a second d₂ diameter of the second opening (4) in the assembly aid (20) and a first diameter d₁ of the thick-layer electrode (15) are adapted to each other in such a way that a force directed in the direction of the arrangement and acting upon the flexible printed circuit board (3) acts upon an edge of the thick-layer electrode in such a way that a seal with respect to the adhesive is made.

10. A method of producing an arrangement according to any one of claims 1 to 8, with the steps:
arranging a flexible printed circuit board (3) in an aligned manner on a piezo actuator (1),
aligning an assembly aid (20) relative to the flexible printed circuit board (3),
pressing the flexible printed circuit board and the piezo actuator with the aid of the assembly aid,
introducing the adhesive into the opening of the printed circuit board and
curing the adhesive.

## Revendications

1. Dispositif composé d'un actionneur piézo-électrique (1) et d'une plaque conductrice souple (3) ayant au moins une liaison mécanique et électrique (5) réalisée par un adhésif électro-conducteur entre un premier contact de branchement (11) sur la plaque de circuit et un second contact de branchement (12) sur l'actionneur piézo-électrique (1),
- la liaison (5) passant par l'ouverture (4) de la plaque conductrice souple (3), et
- les surfaces supérieures collées l'une à l'autre des contacts de branchement (11, 12) ayant chacune un vecteur normal orienté essentiellement parallèlement et de même orientation,
dispositif **caractérisé en ce que**
le second contact de branchement (12) se compose d'au moins une électrode en couche mince (14) avec une épaisseur de couche inférieure à un micron et d'au moins une électrode en couche épaisse (15) ayant une épaisseur de couche supérieure à dix microns.

2. Dispositif selon la revendication 1,
**caractérisé en ce que**
l'électrode en couche épaisse (15) est prévue sur l'électrode en couche mince (14).

3. Dispositif selon la revendication 2,
**caractérisé en ce que**
l'électrode en couche épaisse (15) a une surface inférieure à celle de l'électrode en couche mince (14).

4. Dispositif selon l'une des revendications précédentes,
**caractérisé en ce que**
l'électrode en couche épaisse (15) est de forme circulaire.

5. Dispositif selon l'une des revendications 1 à 3,
**caractérisé en ce que**
l'électrode en couche épaisse (15) est de forme annulaire.

6. Dispositif selon l'une quelconque des revendications précédentes,
**caractérisé en ce que**
l'électrode en couche épaisse (15) a un premier diamètre (d₁) supérieur au diamètre (d) de l'ouverture.

7. Dispositif selon l'une quelconque des revendications précédentes,
**caractérisé en ce que**
l'électrode en couche épaisse (15) et l'ouverture (4) sont orientées concentriquement.

8. Dispositif selon l'une quelconque des revendications précédentes,
**caractérisé par**
une électrode en couche épaisse (15) de forme circulaire et de forme annulaire.

9. Gabarit de montage (20) pour un dispositif selon l'une des revendications précédentes dans lequel, le gabarit de montage (20) est essentiellement en forme de plaque et porte au moins une seconde ouverture (22) dans la région d'au moins une liaison (5),
**caractérisé en ce qu'**
un second diamètre (d) de la seconde ouverture (4) dans le gabarit de montage (20) et un premier diamètre (dl) de l'électrode en couche épaisse (15) sont définis l'un par rapport à l'autre pour qu'une force agissant sur la plaque conductrice (3) et orientée en direction du dispositif agisse sur le bord de l'électrode en couche épaisse pour réaliser l'étanchéité vis-à-vis de l'adhésif.

10. Procédé de réalisation d'un dispositif selon l'une des revendications 1 à 8,
comprenant les étapes suivantes consistant à :
- disposer de manière alignée une plaque souple de circuit (3) sur l'actionneur piézo-électrique (1),
- aligner un gabarit de montage (20) par rapport à la plaque conductrice (3),
- comprimer le conducteur souple et l'actionneur piézo-électrique avec le gabarit de montage,
- introduire l'adhésif dans l'orifice de la plaque conductrice, et
- laisser durcir l'adhésif.
